# EUROPEAN PATENT SPECIFICATION

(11) **EP 2 729 955 B1**
(45) Date of publication and mention of the grant of the patent: **19.12.2018**
(21) Application number: 12737271.2
(22) Date of filing: 16.07.2012
(51) Int. Cl.: H01J 37/34, C23C 14/34, C23C 14/35

(54) **APPARATUS AND METHOD FOR THE PRETREATMENT AND/OR FOR THE COATING OF AN ARTICLE IN A VACUUM CHAMBER WITH A HIPIMS POWER SOURCE**
VORRICHTUNG UND VERFAHREN FÜR DIE VORBEHANDLUNG UND / ODER FÜR DIE BESCHICHTUNG VON EINEM ARTIKEL IN EINER VAKUUMKAMMER MIT EINER HIPIMS STROMVERSORGUNG
APPAREIL ET PROCÉDÉ DE PRÉTRAITEMENT ET / OU DE REVÊTEMENT D'UN ARTICLE DANS UNE CHAMBRE À VIDE AVEC UNE SOURCE D'ALIMENTATION HIPIMS

(30) Priority: 15.07.2011 DE 102011107410
(43) Date of publication of application: 14.05.2014
(73) Proprietor: IHI Hauzer Techno Coating B.V., 5928 LL Venlo (NL)
(72) Inventor: TIETEMA, Roel, NL-5928 Venlo (NL); PAPA, Frank, NL-5928 Venlo (NL)
(74) Representative: Manitz Finsterwald Patentanwälte PartmbB
(86) International application number: PCT/EP2012/063907
(87) International publication number: WO 2013/010990

(56) References cited:
- EP-A1- 1 566 827
- DE-A1-102006 021 565
- DE-U1-202010 001 497
- GB-A- 2 437 080
- US-A1- 2009 194 409

## Description

The present invention relates to an apparatus and to a method for the pretreatment and/or for the coating of an article in a vacuum chamber having at least one cathode arranged therein, having at least one HIPIMS power source and also having a device which generates a tunnel-like magnetic field in front of the surface of the cathode.

An apparatus of this kind is known from the international patent application with the publication number WO 2007/115819. Furthermore, an apparatus of this kind is known from the European patent specification 1 260 603.

Whereas WO 2007/115819 is predominantly concerned with the design of the voltage source for the substrate bias, the present application is concerned with the design of the apparatus and the pulsed power source which is used for the application of the electrical power to the cathode. In so-called HIPIMS sputtering processes (HIPIMS signifies High Power Impulse Magnetron Sputtering) one was originally concerned with the coating process not however with the etching or cleaning process. In the named EP patent specification 1 260 603 the use of HIPIMS is however described in the context of pretreatment of the substrate or of the workpieces in the form of an etching treatment.

Under etching one understands the cleaning of the surface of the substrates or of the workpieces by means of highly energetic ions which strike the surface in the plasma of the vacuum chamber in order, on the one hand, to remove contaminants or surface material and, on the other hand, in order to implant the ions which carry out the etching treatment partly into the surface regions of the substrates of the workpieces. When the etching process is carried out with the same ions as are intended for the coating of the workpiece, or with other compatible elements, a transition layer arises from the substrate to the coating, for example with an increasing concentration of the elements used for the coating or of the elements provided for the adhesion of coating. This leads to an improved bonding of the actual coating on the substrates or on the workpieces.

In the coating mode cathodes of the coating material are used which have a relatively large surface, at least in large machines.

For a pre-specified HIPIMS power source the coating takes place with a current density or power density which is determined by the size or power capability of the HIPIMS power source and the area of the cathode. The same also applies to other pulsed power sources. The corresponding power density, or the power density which may not normally be exceeded because this would like excessive heating of the cathode, is however not ideal for the etching process.

Prior art according to the preamble of the independent apparatus claims is disclosed in DE 20 2010 001 497 Ul. Further prior art is disclosed in US 2009/194409 A1, DE 10 2006 021565 A1, EP 1 566 827 A1, GB 2 437 080 A, and WO 2007/1239021 A1.

The object of the present invention is to so design a coating apparatus of the initially named kind in that it is also favorably designed for the etching process and operates more effectively.

The German utility model 202010001497 is also concerned with this object. The solution presented there, which is entirely practicable, consists - with a coating apparatus of the initially named kind - of an arrangement in which, in addition to at least one coating cathode which is operable with the HIPIMS power source, a plurality of smaller etching cathodes are provided which are of smaller area in comparison to the coating cathode and which can be attached in a predetermined sequence or a presettable sequence to the HIPIMS power source.

In this way, it is possible to achieve a significantly higher peak current density or power density at the individual etching cathode of smaller area, whereby the etching process takes place in an improved and more effective manner. In order to achieve this it is however necessary to provide a switching device which applies the pulses of the HIPIMS power source one after the other to the individual etching cathodes so that a maximum of one etching cathode is fed at any particular point in time with power. In this connection an electronic switching device can take care of the distribution of the individual HIPIMS pulses to the individual cathodes.

Through the known arrangement in accordance with the utility model specification the same HIPIMS power source can be used for the etching cathodes as is used for the coating cathode without the HIPIMS power source having to be made larger, whereby considerable cost and complexity can be saved.

The present invention is concerned with an alternative solution of the object named above and, moreover, it also aims at providing more flexible and better results for a series of coating programs.

In order to solve the object first named above and the further object just recited an apparatus of the initially named kind is provided in accordance with the invention which is characterized in that the device is designed in order to generate the tunnel-like magnetic field in front of a portion of the surface of the cathode and in that the device is displaceable relative to the cathode or energizable to generate the magnetic field to act in front of at least one further portion of the surface of the cathode.

It has namely been recognized in accordance with the invention that the high currents only flow where the tunnel-like magnetic field is present in front of the cathode because the electrons are only concentrated there. Thus, the areal extent of the tunnel-like magnetic field in front of a portion of the cathode can be used in order to concentrate the available power of the HIPIMS power source there, i.e. in that portion. This signifies that a higher power density is present in this portion, whereby the required power density for the etching process, which must be significantly higher than for the actual coating, can be achieved without having to increase the power of the power source which would lead to significantly more expensive and more complicated power sources. As the etching process is only carried out in front of a portion of the cathode at any one time, the etching process admittedly takes somewhat longer, this is however less significant in comparison to the possibility of carrying out the etching process without having to use an excessively large power source.

A particularly simple solution consists in an arrangement in which the device consists of permanent magnets which are arranged behind the rear side of the cathode and in that the device can be displaced in relation to the cathode in order to allow the tunnel-like magnetic field to act in the different portions in front of the cathode. In order to realize this embodiment it is only necessary to displace a suitable arrangement of permanent magnets in relation to the cathode to two, three or four positions (optionally more than four positions) which represents a task which can be straightforwardly satisfied mechanically.

In accordance with a preferred embodiment, the cathode is rectangular with a central longitudinal axis parallel to the longitudinal sides of the rectangle and the device can then be linearly displaced parallel to the central longitudinal axis in order to be active at at least two positions.

The device can for example consist of a ring-like arrangement of permanent magnets which are each arranged with a north pole or a south pole adjacent to the rear side of the cathode. A further permanent magnet of further permanent magnets is or are then arranged within the ring-like arrangement, whereby the polarity of the further magnets or of the further permanent magnets adjacent to the rear side of the cathode is opposite to the polarity of the ring-like arrangement of permanent magnets, i.e. is or are executed with the polarity south or the polarity north respectively.

Furthermore, the ring-like arrangement can be circular or oval and the permanent magnet provided inside the ring-like arrangement can be centrally arranged, or the further permanent magnets arranged inside the ring-like arrangement can be arranged in one or more concentric circles or oval rings.

An apparatus is particularly favorable in which the ring-like arrangement is at least substantially rectangular or square and the further permanent magnets are provided linearly or in a plurality of rows within the ring-like arrangement. In this way rectangular regions of the cathode are exploited in each position of the magnet arrangement for the etching, whereby the total surface of the rectangular cathode can be uniformly worn down by displacement of the magnetic arrangement, which represents an economical solution.

As an alternative to the use of permanent magnets the device can consist of a plurality of electromagnets or coils.

In this connection the device can consist of a ring-like arrangement of coils which are each arranged, depending on the direction of the excitation current, with a north pole or a south pole adjacent to the rear side of the cathode. A further coil or a plurality of further coils can be arranged within the ring-like arrangement, with the direction of the excitation current of the further coil or of the further coils being selected or selectable such that the polarity of the further coil or coils adjacent to the rear side of the cathode is opposite to the polarity of the ring-like arrangement of coils, i.e. is executable as a south pole or a north pole respectively.

In analogy to the arrangement using permanent magnets the ring-like arrangement can be circular or oval and the coil provided within the ring-like arrangement can be centrally arranged, or the further coils arranged within the ring-like arrangement can be arranged in one or more concentric circles or oval rings.

It is likewise possible to design a ring-like arrangement so that it is at least substantially rectangular or square and to provide the further coils linearly or in a plurality of rows within the ring-like arrangement.

In the above-mentioned embodiment with coils these are normally displaced in total in order to allow the tunnel-like magnetic field to act in front of the different portions of the cathode. This is however not essential. Instead of this, the device can be provided with a plurality of electromagnetic coils which are arranged in a manner of a matrix and are stationary. The coils which are arranged in the form of a matrix are then excited group-wise in order to generate a ring-like arrangement of north or south poles adjacent to the rear side of the cathode, while a further coil or further coils is or are excitable within the ring-like arrangement in order to generate an opposite polarity adjacent to the rear side of the cathode, whereby the tunnel-like magnetic field is generated in front of a portion of the cathode associated with the group. By exciting at least one further differently selected group of the magnets or coils arranged in a matrix-like manner, the tunnel-like magnetic field can be generated before at least one further portion of the cathode.

It is particularly favorable in an embodiment of this kind that the cathode can also be operated in its full area in the coating mode from the same power source, by a special selection of the coils arranged in the manner of a matrix, since a lower power density is required for the coating process in comparison with the etching process. In this way, the possibility is provided of being able to use the same cathode both for the etching process and also for the coating process. Purely by way of example it should be pointed out that with a rectangular cathode the groups of the coils that are used can be selected in an etching mode so that a plurality of rectangular arrangements of coils can be used whose longitudinal sides (i.e. the longitudinal sides of the rectangular arrangements) stand transverse to the longitudinal axis of a rectangular cathode, for example over the full width of the cathode, whereas, in a coating mode, the group of the excited coils can be selected such that the longitudinal sides of the rectangular arrangement extend parallel to the longitudinal axis of the cathode and extend over the total length of the cathode.

Since the coils do not have to be moved, i.e. remain stationary in such arrangements, the mechanical complexity for realization of the embodiment is relatively small. It is simply necessary to provide a corresponding number of switches in order to excite the individual coils in the desired sequence of the groups and with the desired polarity. In this connection, semiconductor switches can be used which are commercially available at a favorable price and which are straightforwardly able to switch the required excitation currents.

An apparatus of the type of the invention thus offers a plurality of advantages. First of all, the need to use a plurality of separate etching cathodes is avoided together with the associated complications. Furthermore, with the arrangement in accordance with the invention, one can ensure that the full cathode area is uniformly worn away so that a high material yield is achieved and the expensive cathode material is efficiently exploited. Nevertheless, the size of the pulsed power source or the power yield can be restricted and the temperature of the cathode kept within limits. Furthermore, it seems that the advantages can also be achieved with so-called reactive sputtering, even with materials for which a so-called poisoning of the cathode has to be feared. Under poisoning one understands the formation of an insulating layer on the cathode material that is used, for example an insulating oxide or nitride layer which increasingly impairs the sputtering process. It is also possible to use the same cathode both for the pretreatment or the etching of articles as well as for their coating.

As a rule, the individual substrates or workpieces are associated with a rotatable table in PVD plants in general, particularly in sputtering plants or arc coating plants, with the individual workpieces frequently also being turned during the coating about their own axis. Since the workpiece table or the mounting for the workpieces rotates around the longitudinal axis of the vacuum treatment chamber and the individual workpieces are optionally also turned around their own axes parallel to the longitudinal axis of the vacuum chamber any irregularities in the coating flux from the coating cathode or in the flux of etching ions in the etching process is compensated so that the substrates are uniformly treated or coated over their surfaces. Consequently, it is not disturbing when the individual portions of the etching cathode, which are exploited during etching and which are necessarily arranged spatially alongside one another, each only pretreat some of the workpieces but not all of them. The reason is that through this sequential etching from the different portions of the cathodes a uniform etching treatment of the substrates or workpieces, i.e. of all the substrates or workpieces, can be achieved in total, i.e. when seen in time average.

An alternative coating apparatus is characterized in that the HIPIMS power sources consists of a DC part and a switching part which generate power pulses with a predetermined sequence for the coating cathode and in that the HIPIMS power source is so operatable in the etching mode that it at least supplies further pulses between the power pulses with the preset frequency.

In this connection the switching part of the HIPIMS power source must be slightly changed in order to generate the further power pulses, depending on the specific design of the HIPIMS power pulse. This can however lead to an additional complication of the switching part and this can possibly make it necessary to increase somewhat the power capability (of the DC part) of the HIPIMS power source. In total however a significantly more effective etching process which takes place faster is achieved with less complexity. It should also be stated that the DC part of the HIPIMS power source is the part in which the main cost arises. The switching part is relatively cost-favorable and can be straightforwardly be designed such that it can also work and operate with a higher preset frequency, so that the further pulses are available without this leading to considerable cost.

A further aspect of the invention relates to a method for the pretreatment or the etching of an article which is arranged in a vacuum chamber of a coating apparatus and which is provided with at least one cathode arranged therein and also with at least one HIPIMS power source. The method is characterized in that the cathode(s) is or are provided with a device which generates a magnetic field, the device generating magnetic field lines with components perpendicular to the surface of the cathode(s) at least substantially only in a selected portion of the surface of the cathode and in that the device is moved relative to the cathode(s) or selectively energized in order to allow the magnetic field to act in at least one further portion of the surface of the cathode.

It is particularly favorable when the same cathode which is used for the pretreatment or the etching is also used for the coating of the article, with it being possible for the coating procedure to be followed by a further etching or densification process. This further etching process or densification process can be carried out by way of operation of the cathode on its own, or optionally, additionally by the operation of a further cathode in the same vacuum chamber.

It is particularly favorable when the device which generates the magnetic field in front of the cathode or in front of each cathode consists of a plurality of electromagnets or coils which can be energized in different groups to generate a magnetic field before selected portions of the cathode or before the full cathode. Such coils can be realized in a favorable price and also enable a simple control of the intensity of the magnetic field by a control of the excitation current. Furthermore, the polarity of the coils can be simply changed by switching over the direction of the current. The coils can either be displaced altogether or a larger number of coils can be provided in a matrix arrangement behind the total area of the cathode and individual coils excited in groups in order to generate a respectively desired magnetic field. In this connection, moving parts can be advantageously avoided.

Particularly favorable variants of the method and apparatus of the invention can be found in the further patent claims and in the further description.

The invention will now be explained in more detail in the following with reference to embodiments and to the drawings, in which are shown:
- Fig. 1: Fig. 1 of WO 2007/115819 which shows the basic design of a magnetron sputtering plant with a HIPIMS power source,
- Fig. 2: a representation of the power impulse sequence of a HIPIMS power source as can be used in the apparatus of Fig. 1 and in the present invention,
- Figs. 3A to 3D: a series of schematic illustrations to explain the apparatus of the invention,
- Figs. 4A and 4B: two schematic representations to explain an alternative embodiment of the apparatus of the invention,
- Fig. 5: a further schematic illustration to explain a further possible embodiment of an apparatus in accordance with the invention,
- Fig. 6: a block circuit diagram to explain the design of the HIPIMS power source which can be used in the coating apparatus of the invention,
- Fig. 7: a possible scheme for the timing of the pulses which are applied to the individual cathodes,
- Figs 8A and 8B: a perspective view and a plan view of a device in accordance with the invention in the form of a permanent magnet,
- Fig 9: a schematic diagram of a further embodiment of the present invention and
- Figs. 10A and 10B: two schematic diagrams showing possible designs of electromagnetic coils, with Fig. 10A showing an electromagnetic coil suitable for use in the device of Figs. 3A to 3D (and in the devices of Figs. 4A, 4B and 5) and Fig. 10B showing electromagnetic coils suitable for use in an electromagnetic variant of Fig 9.

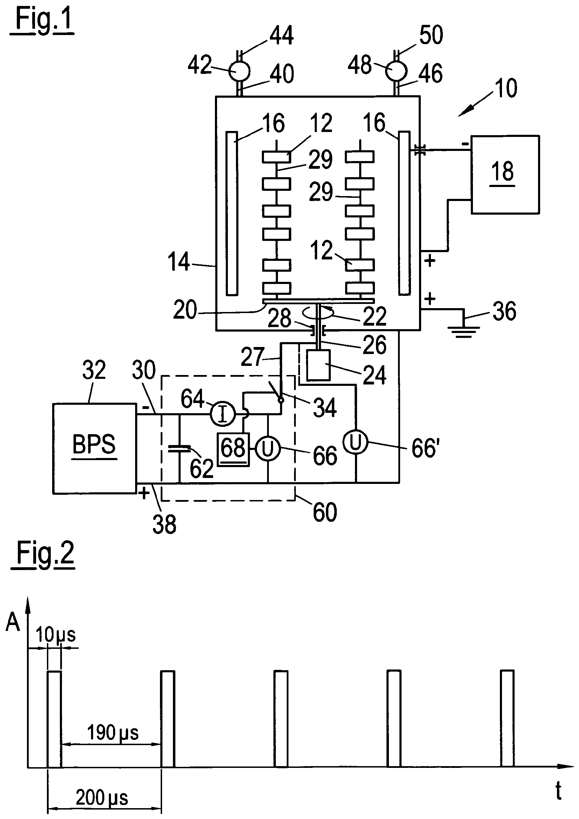

Referring now to Fig. 1 a vacuum coating apparatus 10 is shown there for the treatment and coating of a plurality of substrates 12. The apparatus consists of a vacuum chamber 14 of metal which in this example has two oppositely disposed cathodes 16 which are each equipped with their own HIPIMS power source 18 (of which only one is shown here) for the purpose of generating ions of a material which is present in the gas phase in the chamber and/or ions of the material from which the respective cathode or cathodes is or are formed. The substrates (workpieces) 12 are mounted on a substrate carrier 20 in the form of a table which can be rotated in the direction of the arrow 22 by an electric motor 24 which drives a shaft 26 which is connected to the substrate carrier. The shaft 26 passes through a feed-through 28 at the base of the chamber 14 in a sealed and insulated manner which is well known per se. This permits a terminal 30 of the substrate bias supply 32 to be connected via a line 27 to the substrate carrier 20. This substrate bias voltage supply 32 is designated here with the letters BPS which is an abbreviation for Bias Power Supply. The substrates 12 which are mounted on the vertical columns 29 are hereby connected to the voltage which is present at the terminal 30 of the bias voltage supply 32 when the switch 34 is closed.

In this example a metallic housing 14 of the apparatus 10 is connected to earth 36 and this is at the same time the positive terminal of the apparatus. The positive terminal of the HIPIMS power source 18 is likewise connected to the housing 14 and thus to earth 36 as is also the positive terminal 38 of the substrate bias supply 32.

At the upper part of the vacuum chamber (although this position is not critical) there is a connection stub 40 which is connected via a valve 42 and a further line 44 to a vacuum system for the purpose of evacuating the treatment chamber 14. The vacuum system is not shown is however well known in this field. A further line 50 which enables the supply of one or more suitable gases into the vacuum chamber 14 is likewise connected to the upper part of the vacuum chamber via a valve 48 and a connection stub 46. For example an inert gas such as argon can be introduced into the vacuum chamber, as well as gases such as nitrogen or acetylene for the deposition of nitrides or carbon coatings or carbon nitride coatings by reactive sputtering. Separate connections similar to the connections 46, 48, 50 can likewise be provided, if desired, for different gases.

Vacuum coating apparatuses of a generally described kind are known in the prior art and are frequently equipped with more than two cathodes 16. For example, a vacuum coating apparatus is available from the company Hauzer Techno Coating BV in which the chamber 10 has a generally octagonal design in cross-section with two doors which open outwardly of which each carries one, two or three magnetron cathodes 16. These cathodes can consist of the same material, but normally consist of different materials, so that coatings can be built up from different materials in layers on the substrates or articles such as 12.

A typical vacuum coating apparatus includes a plurality of further devices which are not shown in the schematic drawing of Fig. 1, such as dark field shields, heating devices for the preheating of the substrates 12 and sometimes electron beam sources or plasma sources in diverse forms. In addition it is possible to provide arc cathodes in addition to magnetron sputtering cathodes in vacuum coating apparatus.

When using the apparatus the air which is initially present in the vacuum chamber 14 is evacuated by the vacuum pumping system via the line 44, the valve 42 and the line 40 and an inert gas such as argon and/or active gases flow into the chamber via the line 50 the line 48 and the connection stub 46. Accordingly, the air which is initially present in the chamber is removed from this and the vacuum chamber 14 is flushed with inert gas and/or reactive gases. At the same time, or following this, the heating devices (not shown) can be operated in order to preheat the substrates and to drive out any volatile gases or compounds which are present at the articles 12.

The inert gas which is introduced into the chamber is necessarily ionized to a certain degree, for example as a result of cosmic radiation. It splits up into electrons and inert gas ions, for example argon ions. The argon ions are drawn to the cathodes and collide there with the material of the target, i.e. of the cathodes, whereby atoms of the cathode material are knocked out and secondary electrons are generated. A magnet system (not shown but well known per se) is associated with each of the cathodes and normally generates a magnetic tunnel in the form of a closed loop which extends over the surface of the cathode. This magnetic tunnel, present as a closed loop, forces electrons to move in orbits around the closed loop and to cause further ionization by collisions. These secondary electrons thus lead to a further ionization of the gas atmosphere of the chamber which in turn leads to the generation of further inert gas ions and ions of the material of the cathode 16. These ions can be attracted to the articles 12 by a substrate bias voltage at a suitable level, for example from -700 to -1200 V and be caused to strike the articles with an adequate energy and to etch the surface of the articles.

As soon as the etching treatment has been carried out, the coating mode can be switched on which leads, with a suitable power supply for the cathode, to a flux of atoms and ions of the cathode material moving into the space which is occupied by the workpieces 12 which rotate on the substrate carrier. The workpieces or substrates 12 are then coated with the material of the cathode. If a reactive gas such as acetylene is present in the vacuum chamber then a corresponding coating forms on the substrates. For example, if the cathode consists of Ti, the acetylene (C₂H₂) is split up into C atoms and H atoms and a coating of TiC arises on the workpieces. The hydrogen is partly deposited in the coating and partly removed via the vacuum system from the vacuum chamber. The moving of the ions in the direction towards the substrates 12 on the substrate carrier 20 is brought about by the negative bias which is applied to the substrate holder 20 and thus to the substrates. Other non-ionized material atoms of the cathode 16 receive adequate kinetic energy so that they also enter the space before the cathode 16 and there form a coating on the articles 12. As a result of the substrate bias the inert gas ions are likewise attracted by the substrates, i.e. by the workpieces and serve to increase the density of the coating. It will be understood that the bias voltage which is applied to the substrates causes them to attract the ions of the cathode material which are knocked out of the surface of the cathode and which form in the plasma in front of the cathode 16.

Sputtering processes are known in the most diverse embodiments. There are those which are carried out with constant negative voltage at the cathode 16 and a constant negative bias voltage at the substrate holder. This is described as DC magnetron sputtering. Pulsed DC sputtering is likewise known in which at least one of the cathode supplies is operated in a pulsed mode. In addition the bias voltage supply for the substrate carriers can likewise be operated in a pulsed mode. This can in particular be of advantage with cathodes of a semi-insulating material.

In a DC magnetron sputtering process of this kind the power which is consumed for each cathode 16 can for example lie between 16 to 20 kW.

In more recent time the cathodes are however not supplied with a constant DC current but rather a much higher power is used which, however, is only applied in relatively short impulses. For example the power impulse as shown in Fig. 2 from the HIPIMS power source 18 can be generated with a time duration of 10 µs and a pulse repetition time of 200 µs corresponding to a pulse repetition frequency of 5000 Hz, i.e. a spacing between sequential pulses of 190 µs. The values that are quoted are simply given by way of example and can be varied within wide limits. For example one can straightforwardly operate with a pulse duration in the range between 10 µs and 3 ms and with a pulse interval between pulses of between 20 µs and 6 ms. As the time in which a very high power is applied to the cathodes is restricted the average power can be kept at a moderate level corresponding to the power level during normal magnetron sputtering in a DC mode. It has however been found that, by the application of high power impulse to the cathode or the cathodes, these operate in a different operating mode in which a very high degree of ionization of metal vapor arises which starts from the cathode or the cathodes, with this degree of ionization being able to lie straightforwardly in the range between 10 % and even up to 100 %. As a result of this high degree of ionization many more ions are attracted by the substrates and arrive there with higher speed which leads to more dense coatings and trench filling.

The fact that this power is concentrated in power peaks lead however to relatively high currents flowing in the bias power supply for the substrates during these power peaks. The current take-up cannot be straight forwardly delivered by a normal bias power supply.

In order to overcome this difficulty an additional voltage source 60 is provided in accordance with the solution shown in WO 2007/115819 which is indicated here in Fig. 1. This voltage source 60 is most simply realized by a capacitor which is charged by a customary bias voltage supply and indeed to a voltage which corresponds to the desired output voltage. When the power is supplied by the HIPIMS power supply 18 to the cathode 16 then this leads, as explained above, to a material flux which consists essentially of ions from the cathode 16 and which is directed to the substrates 12. This increase of the ion flux signifies an increase of the current at the substrate holder 20 and through the line 27 to, for example, about 40 amperes. A normal bias voltage supply 32 could not deliver such a high peak current if designed for DC operation instead of HIPIMS operation. However the capacitor 62 which is charged by the bias power supply in the pauses between the individual high power impulses of the cathode supply 18 is able to keep the desired bias voltage at the substrate holder 20 within narrow limits and to supply the required current which only causes a small discharging of the capacitor. In this way, the substrate bias voltage remains at least substantially constant.

For example, the discharge can take place in such a way that a bias voltage of for example -50 V, which is provided during the coating process drops to for example -40 V.

It should be pointed out that further undesired voltage drops can also occur during the etching process in which the bias voltage of the substrate carrier and of the substrates lies at substantially higher values, for example from somewhat below -700 V to -1200 V.

The bias supply voltage 32 in the form shown in Fig. 1 is thus basically capable of enabling a HIPIMS magnetron sputtering process.

For the same of completeness it should be pointed out that the bias voltage supply 32 can also be equipped with an arc protection function. For example detectors such as 64 can be provided to detect the current flowing in the line 32 and can be used to actuate a semiconductor switch 34 in order, in the event of an arc arising, to open the switch 34 and thus to interrupt the bias supply at the substrate holder 20 or substrate carrier and to hereby bring about the extinguishing of the arc. The detector 66' shows an alternative position for the detector 66 which is here realized as a voltage detector. Further modifications and embodiments are described in the named WO 2007/115819.

The present invention is concerned with improving the etching process.

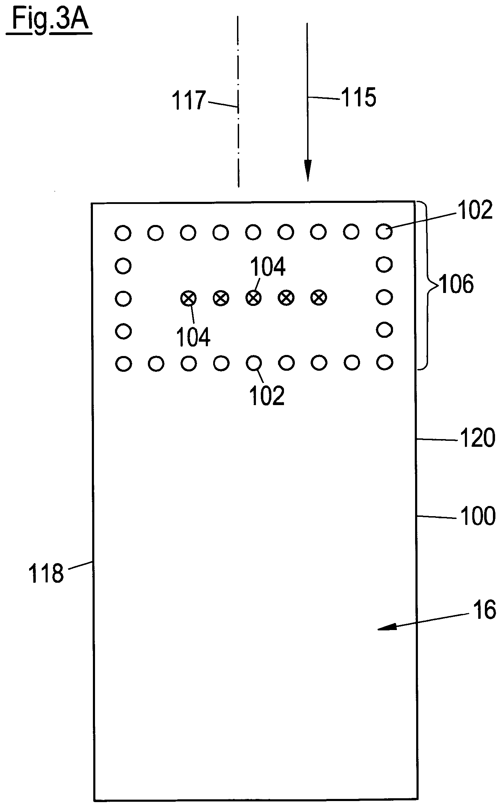

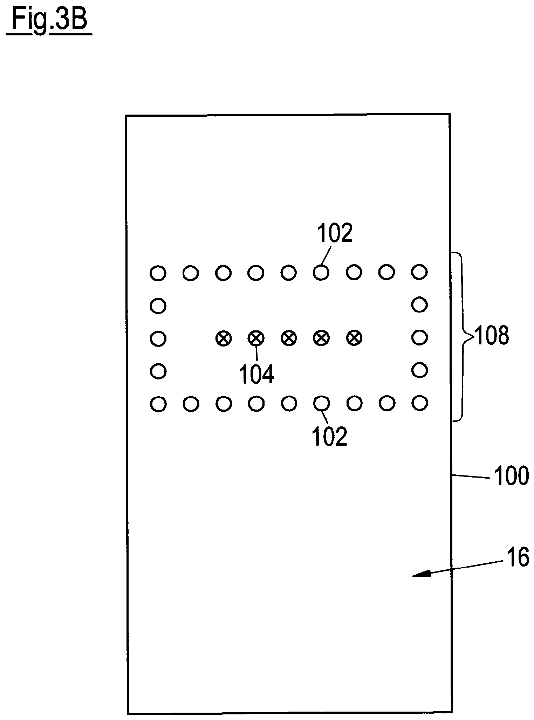

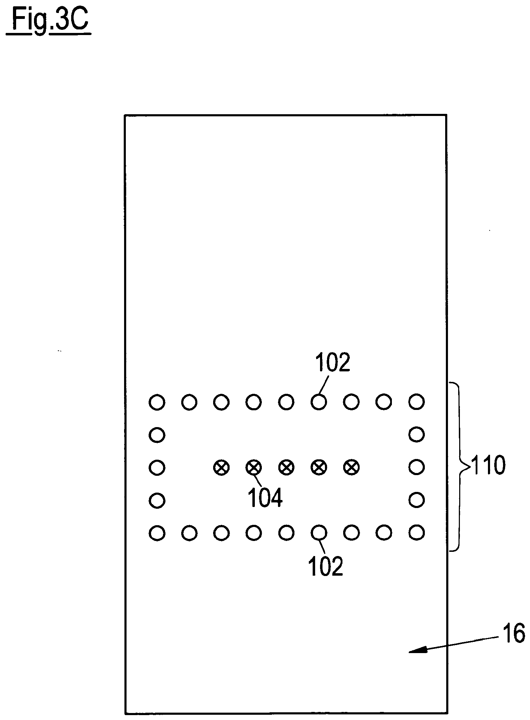

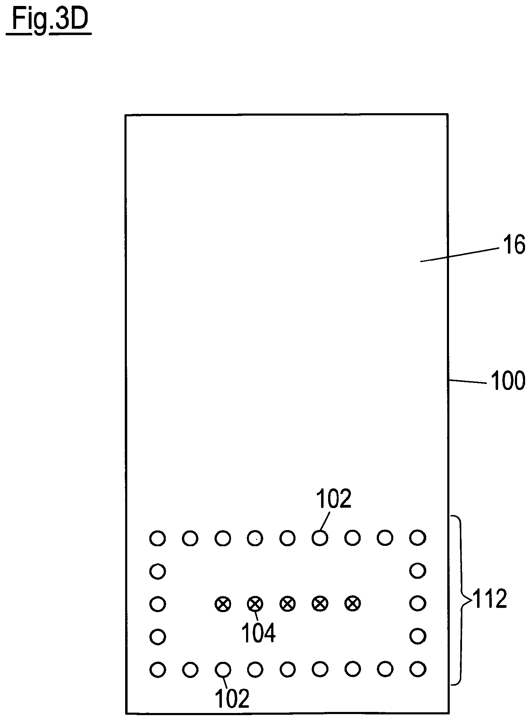

Fig. 3A shows in schematic form, with the outline 100, a plan view of an etching cathode which can be used as a cathode 16 at the right hand side of Fig. 1. A device 101 is also provided consisting of a plurality of permanent magnets 102, 104 which serves for the generation of a tunnel-like magnetic field in front of the surface of the cathode 16. The device 101 is designed such that the tunnel-like magnetic field is only generated in front of a portion 106 of the surface of the cathode, i.e., in Fig. 1, in front of the left side of the rectangular cathode 16 shown there. For this purpose the permanent magnets are arranged behind the cathode 16, i.e. in Fig. 1 at the right hand side of the right hand cathode 16. The device consists of a plurality of permanent magnets 102, 104 which are mounted on a non-shown suitable carrier plate or on a non-shown suitable carrier frame and which is linearly movable in the direction of the arrow 115 along the longitudinal axis 117 of the cathode. In this way the device can also adopt the further positions with reference to the cathode 16 in accordance with Figs. 3B, 3C and 3D in which the tunnel-like magnetic field acts in front of the further portions 108, 110 and 112 of the surface of the cathode 16.

The device 101 consists, as stated, of the permanent magnets 102, 104 which are arranged behind the rear side of the cathode 16 and the device 101 is linearly displaceable in relation to the cathode 16 in the arrow direction 115 in order to allow the tunnel-like magnetic field to act in the different portions 106, 108, 110 and 112 in front of the cathode. In this connection the device dwells in each of the positions shown in Figs. 3A to 3D, could however also be continuously moved to and fro along the longitudinal axis 117 thereby continuously traversing the portions 106, 108, 110 and 112.

In this embodiment the cathode 16 is rectangular with its central longitudinal axis 117 parallel to the longitudinal sides 118, 120 of the rectangle 100 and the device 101 is linearly displaceable parallel to the central longitudinal axis 117 and is active in at least two positions (in Figs. 3A to 3D in four positions).

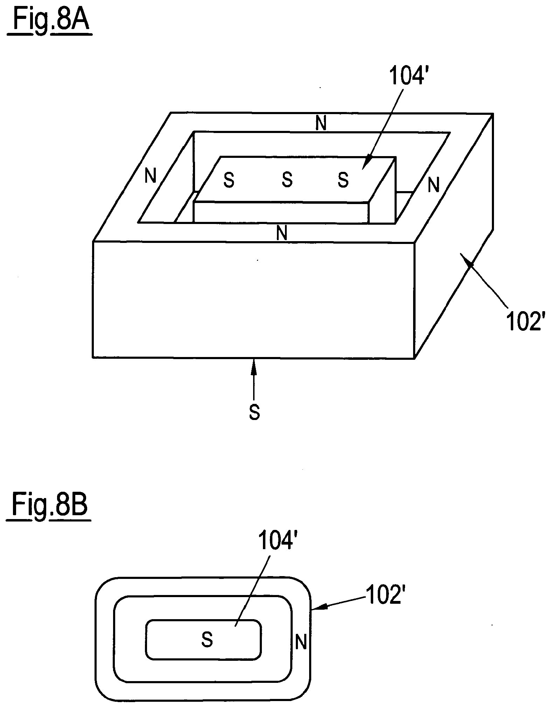

The device 101 consists specifically of a ring-like arrangement of permanent magnets 102 which are each arranged with a north pole or with a south pole adjacent to the rear side of the cathode 16. Here it is assumed that the permanent magnets 102 have north poles in the plane of the drawing of Figs. 3A to 3D, which is indicated by the representation as a circle. They can be formed by bar magnets the south poles of which are then disposed behind the plane of the drawing. In this example a plurality of further bar magnets 104 is arranged within the ring-like arrangement of permanent magnets 102 and have a polarity which is opposite to the polarity of the ring-like arrangement of permanent magnets 102, i.e. they are executed in this example with south poles in the plane of the north poles of the ring of magnets 102, which is indicated by the representation as a circle with cross. The permanent magnets 104 can also be formed by bar magnets the north poles of which then lie behind the plane of the drawing. The permanent magnets do not have to be executed as bar magnets. For example, as shown schematically in Figs. 8A and 8B the magnets 102 can be formed by surface regions of a ring magnet 102' with its north side upwardly in Fig. 8A and its south side downwardly in Fig. 8A. The magnets 104 can also be formed by a linear magnet 104' in Figs 8A and 8B the south side of which lies upwardly in Fig. 8A and the north side downwardly as shown by the respective letters N and S. Also discrete bar magnets, e.g. of square cross section can be placed directly alongside one another to form the ring-like arrangement 102 and the linear arrangement 104. In all variants north and south can also be interchanged. In the two cases the permanent magnets form the required tunnel-like magnetic field in front of the respective portion 106, 108, 110 and 112 of the surface of the cathode 16.

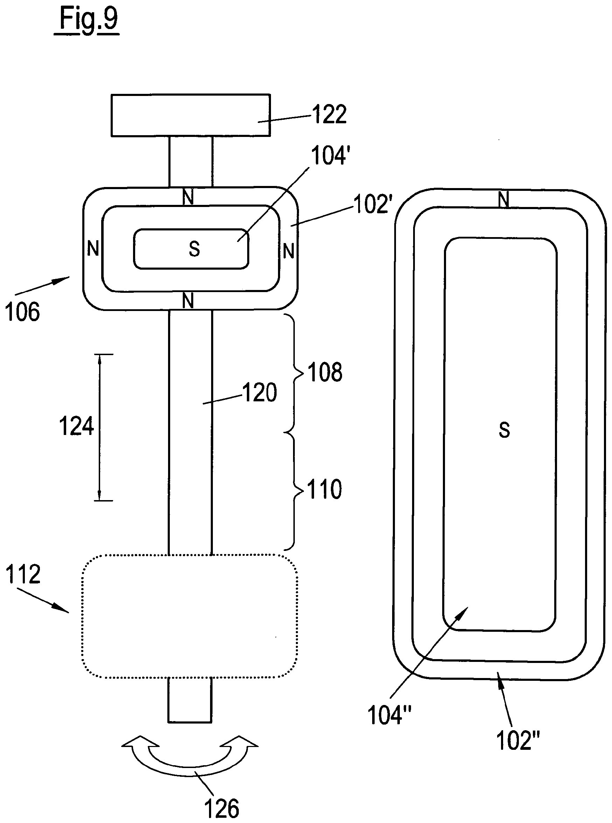

One way of achieving this is shown at the left hand side of Fig.9 in which the device of Figs. 8A and 8B, i.e. the ring magnet 102' and the linear magnet 104', are mounted via a recirculating ball nut (not shown) on a threaded spindle 120 which can be rotated in the direction of the double arrow 126 by a stepping motor 122 to move the ring magnet and the linear magnet upwardly and downwardly in the direction of the double arrow 124 along the spindle from the position 106 to the position 112 (through the further positions 108 and 110. The two directions of movement are obtained by changing the polarity of the drive current to the stepping motor 122. The two magnets 102' and 104' are moved as a unit and guides (not shown) are provided to ensure the poles of the magnets 102' and 104' are maintained parallel to the rear face of the associated cathode which is not shown in Fig. 9 but will be understood to be positioned in front of the magnets 102' and 104' and to have an area corresponding to that of the magnet arrangement shown at the right hand side of Fig. 9.

The magnets 102" and 104" shown at the right hand side of Fig. 9 have the same general shape as the magnets 102' and 104' shown in Figs. 8A and 8B and at the left hand side of Fig. 9 but have been turned through 90° and expanded so that they cover the full area of the rear side of the cathode and can generate a tunnel-like magnetic field over the full front face of the cathode so that the cathode can also be used for coating. The concept is to interchangeably mount the two magnet arrangements, i.e. the pair of magnets 102', 104' and the pair of magnets 102", 104" so that the magnet pair 102', 104' can be used in different positions such as 106, 108, 110 and 112 for the pretreatment or etching operation and then be replaced by the magnet pair 102", 104" so that coating can take place from the same cathode using the same HIPIMS power supply. The magnet pairs 102', 104' and 102", 104" could be completely separate from one another and simply be moved into place behind the relevant cathode during the use of the vacuum coating apparatus or they could be coupled together for automatically changing between the two magnet pairs.

One way of doing this could be to make the spindle 120 longer and to also couple the larger magnet pair 102", 104" to the same spindle via a further recirculating ball nut. If a suitable space is provided between the magnet pair 102', 104' and the magnet pair 102", 104" then it can be ensured that only one magnet pair is in use at any one time.

There are however many different ways the two magnet pairs could be automatically brought into position behind the respective cathode with either a coupled arrangement of the two magnet pairs as just described or with a non-coupled arrangement with autonomous drives for the two magnet pairs.

It should also be mentioned that all the different embodiments disclosed in this application can be realized as balanced or unbalanced magnetrons as desired.

It should be noted that in this embodiment, as in the other embodiments, the coating operation can also be followed by a further etching or densification operation again using the same HIPIMS power supply to the cathode and generally using the magnet pair 102', 104,' although it is also possible to carry out a densification process using the larger magnet pair 102", 194".

Generally speaking etching or pretreatment will be carried out using the magnet pair 102', 104' in different positions and with a substrate bias typically in the range from -700V to -1200V (although these values are to be considered as exemplary and non-restrictive). Coating will generally be carried out with a lower substrate bias typically in the range from 0V to - 180V (again these values are to be considered as exemplary and non-restrictive) using the larger magnet pair 102", 104" and the full area of the cathode. Densification will typically be carried out using either of the magnet pairs 102', 104' or 102", 104"and a substrate bias typically in the range from -200V to -400V (again these values are to be considered as exemplary and non-restrictive).

This brief description of the pretreatment, etching, coating and densification processes will be understood to apply to all the examples given in this specification.

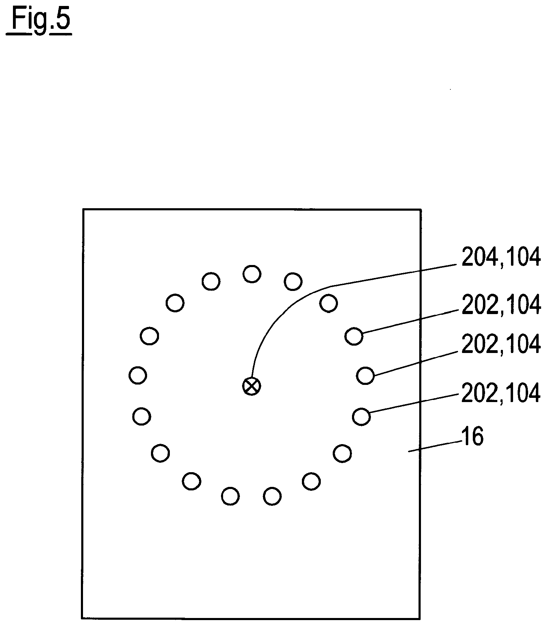

In accordance with another embodiment, which is indicated in Fig. 5, the ring-like arrangement is circular (or oval) and the permanent magnet 104 arranged inside the ring-like arrangement is centrally arranged. An arrangement is also conceivable in which the further permanent magnets 104 arranged within the ring-like arrangement are disposed in one or more concentric circles (or oval rings).

It is particularly favorable when the ring-like arrangement of the permanent magnets 102 is at least substantially rectangular or square and the further permanent magnets 104 are linearly provided (or in a plurality of rows - not shown but easily understood) within the ring-like arrangement, as shown in Figs. 3A to 3D.

The device 101 can also be realized in such a way that the permanent magnets 102 and 104 are replaced by individual electromagnets or coils and the Figs. 3A to 3D and 5 apply in just the same way for such an embodiment. The above stated applies without restriction for the use of coils instead of permanent magnets 102, 104. Coils have the additional advantage that the magnetic field strength can be straightforwardly changed by controlling the excitation current.

When using a ring-like arrangement of coils the coils, if of the same design, can each be realized with a north pole or a south pole adjacent to the rear side of the cathode 16, depending on the direction of the excitation current. The further coils within the ring-like arrangement can equally be realized with a south pole or a north pole adjacent to the rear side of the cathode 16 by the selection of the direction of the excitation current.

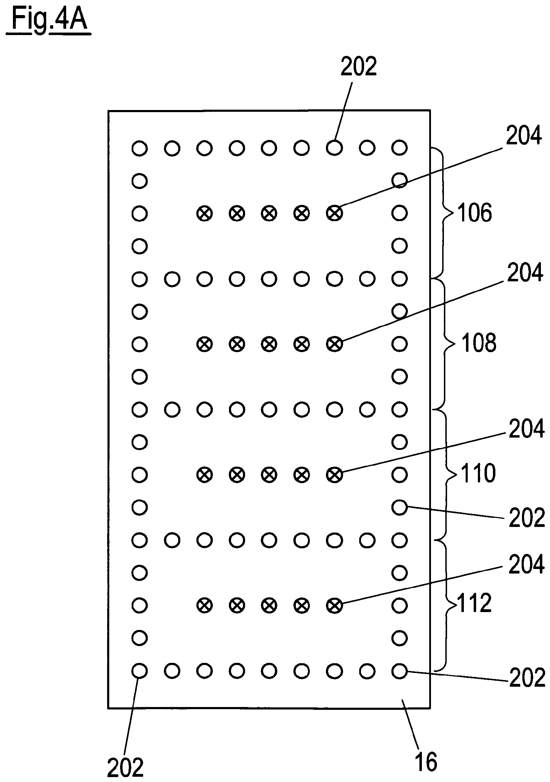

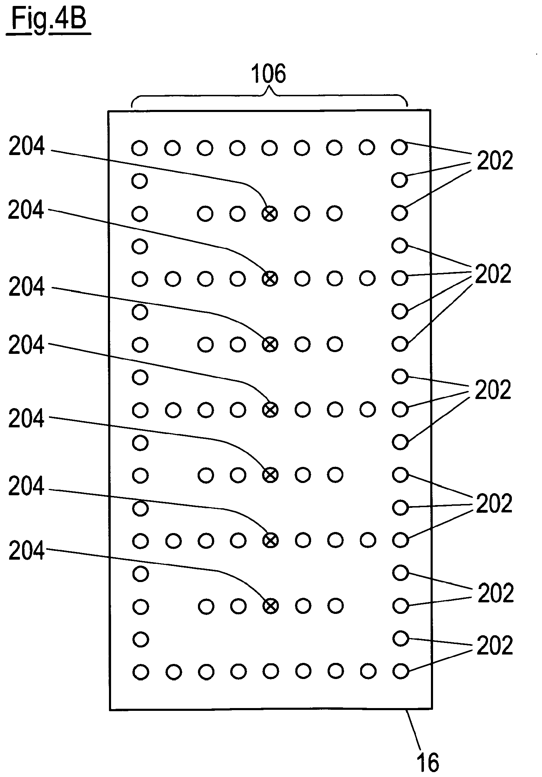

In a particularly preferred embodiment in accordance with Figs. 4A and 4B the device 201 consists of a plurality of stationary electromagnets or coils 202, 204 arranged in the manner of a matrix.

These coils 202, 204 can be selected group-wise so that tunnel-like magnetic fields arise in the individual portions or sections 106, 108, 110 and 112 of the cathode 16 as shown in Figs. 3A to 3D without the need to displace the coils 202, 204. Only those coils 202 and 204 are selected which are required in order to generate the respective tunnel-like magnetic field. The direction of the excitation current in the individual coils is then selected by means of suitable switches (not shown), so that the respectively desired polarity arises in accordance with Figs. 3A to 3D.

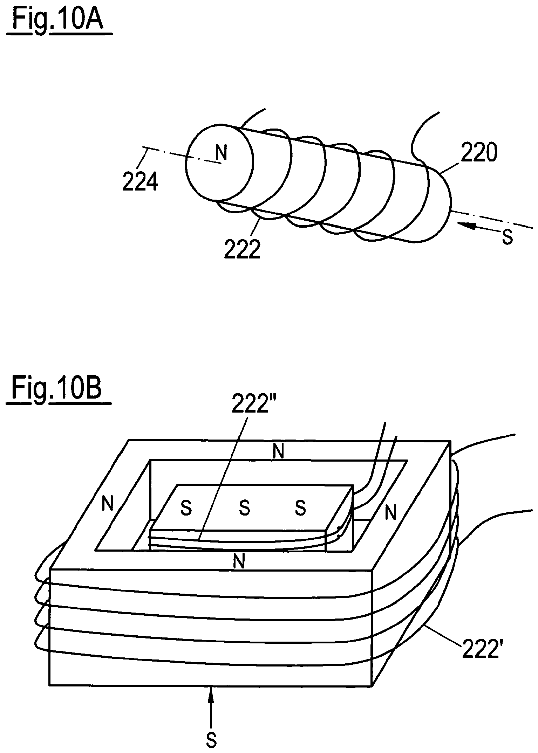

This can easily be understood by considering Fig. 4A. This embodiment makes it possible to utilize the same cathode for the coating of workpieces in which the full area of the cathode is active at any point in time. For example, four tunnel-like magnetic fields can be alternatingly or simultaneously generated in the sections 106, 108, 110 and 112 in accordance with Fig. 4A, or the coils can be so excited as shown in Fig. 4B so that a tunnel-like magnetic field is present in front of the entire front side of the cathode 16. Simply for the sake of completeness a simple electromagnet is shown in Fig. 10A in a perspective view it comprises a ferromagnetic core 220 and an excitation coil 222 wound around the core. The design is such that, depending on the direction of the current flowing through the coil (and the direction of winding of the coil around the core 220) one end of the electromagnet is a north pol N and the other end a south pole S. The axis 224 of the electromagnet is arranged perpendicular to the plane of the associated cathode.

Fig. 10B shows that an electromagnet can also be realized with a ring core and a linear core in analogy to the permanent magnet designs of Fig. 9. Separate coils 222' and 222" are required for each of the ring core and the linear core.

The required switching over of the coils can then be effected with the aid of switches in particular of semiconductor switches.

In the embodiment of Fig. 1 the cathode 16 at the right hand side of the apparatus shown is used for the etching process and is operated with the same pulse sequence as shown in Fig. 2 but with a bias voltage which is selected for the etching process at higher values such as for example (-700 to -1200 V).

As the individual portions 106, 108, 110 and 112 of the cathode 16 each have a substantially smaller surface than the total cathode 16 a substantially higher peak current density can be achieved in the individual portions 106, 108, 110 and 112 than in front of the entire cathode 16.

When the etching is effected by the individual portions 106, 108, 110 and 112 the total cathode is connected to the HIPIMS power source since the local tunnel--like magnetic field in front of the respectively active portion 106, 108, 110, 112 ensures that the power is largely only applied there, i.e. that only there are energy-rich ions produced which are suitable for the etching process.

The coating cathode and the etching cathodes can consist of any desired materials. Purely by way of example the coating cathodes can consist of titanium, zirconium, aluminum, tungsten, chrome, tantalum or their alloys, optionally with smaller additives of additional elements such as niobium or borium and with also small additions of rear earths such as Sc, Y, La or Ce. Carbon cathodes 16 can also be considered, for example of graphite. As reactive gases one can here use gases such as nitrogen or acetylene amongst others.

It is particularly favorable when an inert gas such as neon, argon, krypton or zenon is used for the etching process and cathodes of chromium, vanadium, titanium, zirconium, molybdenum, tungsten, niobium or tantalum are provided for the etching process i.e. etching cathodes 16A to 16D can consist of these elements (i.e. Cr, V, Ti, Zr, Mo, W, Nb, Ta) or also of other elements or alloys if this is desired.

An etching process is normally carried out with an argon pressure in the range from 10⁻⁵ to 10⁻¹ mbar, for example at 10⁻² mbar.

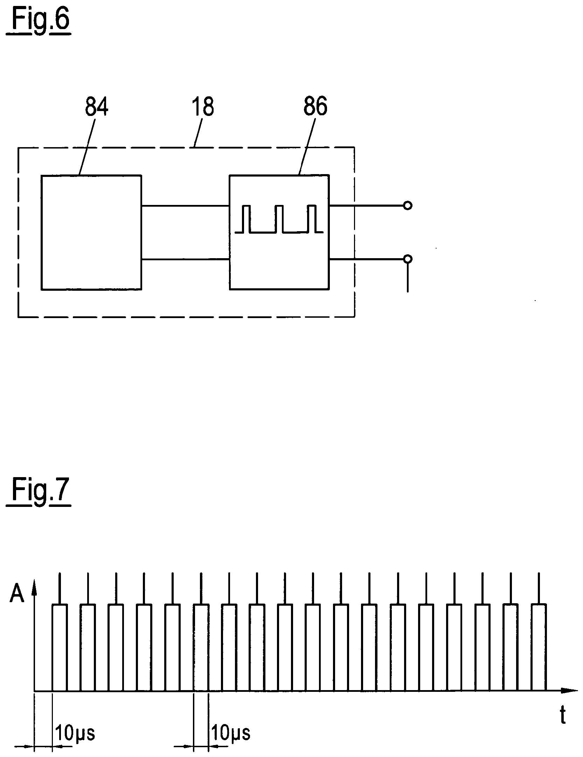

As can be seen from Fig. 6 the HIPIMS power source normally consists of a DC part 84 and a switching part 86 which generates from the output power of the DC part 84 power impulses for the coating cathode as shown in Fig. 2 at the desired or preset frequency. The power impulses can also be superimposed on a constant DC voltage. This can make it possible to maintain the ionization in the chamber, or a certain degree of ionization in the chamber, during the period between pulses, which enables the pulses to operate more effectively to enhance the ionization.

In accordance with an example of the invention the etching cathode 16 and the further coating cathode 16 can be rectangular with a length and width of 100 cm x 17 cm, i.e. an area of 1700 cm². A coating cathode of this kind is normally operated in the HIPIMS mode with 360 kW having a peak current of 600 A. This results, with a surface of approximately 1700 cm², in a power density of approximately 212 W per cm² and a current density of approximately 0.35 A/cm². When the etching takes place starting from the portions 106, 108, 110 and 112 then for each etching cathode an area results of 425 cm² and this signifies, for the same power supply, a surface power or power density of approximately four times, i.e. 848 W/cm² and a correspondingly higher current density.

The coating apparatus or the HIPIMS power source can also be designed otherwise. For example the switching part 86 can be so designed or controlled that the HIPIMS power source 18 can be operated in the etching mode so that it delivers at least further pulses in addition to the power impulses with the preset frequency, i.e. power pulses having a higher frequency. These power pulses are then be delivered in accordance with

Fig. 7 to the respectively active portion 106, 108, 110 or 112 of the etching cathode. As indicated by the short narrow lines adjacent each pulse the pulses can be made narrower if the frequency of the pulses is increased for etching. The values shown in Figs. 3 and 7 are purely by way of example and are not to be understood as restricting the invention in any way.

The basic concept of the invention thus lies in moving a small matrix of permanent magnets, rectangular or circular with a central pole up and down along the longitudinal axis of a planar magnetron.

This enables a localized high power discharge with absolutely low peak powers and currents. Also the entire surface of the cathode is active. This can also prevent the renewed deposition of material.

The main advantages are:
1) HIPIMS etching is effected with power densities above 1000 W/cm². In this case, one can always work below this value. For example with a Flexi-coat 850 cathode the present applicants generate, with a surface of 750 cm² in the magnet arrangement, a plasma with a higher density is generated in an area of 150 cm² (i.e. in the respective portion of approximately one fifth of the total area of the cathode) (although the size of this area can also be selected differently). The average power density over the surface of the cathode lies at approximately 200 W/cm² (100 W/cm² / 5) when seen in time average.
2) Absolutely low peak powers and the peak currents can be achieved by the present invention and are of advantage for the discharge with a higher density. For example, for a full area plasma of higher density, one requires for 750 cm² and 750 kW peak power a discharge current of 1000 A. For the new embodiment one requires 150 kW peak power and 200 A discharge current.
3) The requirements placed on the power supply device are low. For example a 750 cm² discharge during etching could require a peak bias current of 300 - 400 A. This corresponds to a peak power of the bias apparatus at 800 V bias voltage of 240 - 320 kW. With the new design a peak bias current of 60 - 80 A could be achieved. This corresponds to a peak power of 48 - 64 kW at 800 V. This would substantially facilitate the handling of undesired arcing and substantially reduce the danger of damage due to arcing, probably as a result of the smaller available energy in the arc.
4) Full area erosion of the target, i.e. of the cathode, can be achieved.
5) Possibly the arrangement can also be used for the reactive deposition of insulating materials, for example Al₂O₃, AlN, SiN.

## Claims

1. An apparatus (10) for the pretreatment and/or for the coating of an article in a vacuum chamber (14) having at least one cathode (16) arranged therein, having at least one HIPIMS power source (18) and also having an electromagnetic arrangement (101; 201) adapted to be energizable to generate a tunnel-like magnetic field in front of the full surface of the cathode,
wherein the electromagnetic arrangement (101; 201) is also adapted to be energizable to generate the tunnel-like magnetic field in front of a portion (106, 108, 110, 112) of the surface of the cathode (16) and wherein the electromagnetic arrangement is also adapted to be energizable to generate the magnetic field to act in front of at least one further portion (106, 108, 110, 112) of the surface of the cathode (16).

2. An apparatus (10) for the pretreatment and/or for the coating of an article in a vacuum chamber (14) having at least one cathode (16) arranged therein, having at least one HIPIMS power source (18) and having a first permanent magnet arrangement adapted to generate a tunnel-like magnetic field in front of the full surface of the cathode, **characterized in that**
a second permanent magnet arrangement (101; 201) is provided which is adapted to generate the tunnel-like magnetic field in front of a portion (106, 108, 110, 112) of the surface of the cathode (16) and **in that** the second permanent magnet arrangement is adapted to be displaceable relative to the cathode (16) to generate the magnetic field to act in front of at least one further portion (106, 108, 110, 112) of the surface of the cathode (16).

3. An apparatus (10) in accordance with claim 1 wherein the electromagnetic arrangement comprises a first and second electromagnetic arrangement, the first electromagnetic arrangement is adapted to generate a tunnel-like magnetic field in front of the full surface of the cathode, the second electromagnetic arrangement is adapted to generate the tunnel-like magnetic field in front of a portion (106, 108, 110, 112) of the surface of the cathode (16) and wherein the second electromagnetic arrangement is further adapted to be displaceable relative to the cathode (16) to generate the magnetic field to act in front of at least one further portion (106, 108, 110, 112) of the surface of the cathode (16).

4. An apparatus (10) in accordance with claim 2,
**characterized in that** the first permanent magnet arrangement (102, 104) is arranged behind the rear side of the cathode (16) and **in that** the second permanent magnet arrangement (101) is displaceable in relation to a cathode (16) in order to allow the tunnel-like magnetic field to act in front of the cathode in the different portions (106, 108, 110, 112).

5. An apparatus (10) in accordance with claim 2 or claim 3, **characterized in that** the cathode (16) is rectangular having a central longitudinal axis (117) parallel to the longitudinal sides (118, 120) of the rectangle and **in that** the second permanent magnet arrangement (101) or the second electromagnetic arrangement is linearly displaceable parallel to the central longitudinal axis and is active in at least two positions for the generation of the magnetic field in the respective portion.

6. An apparatus (10) in accordance with claim 2 or claim 5, **characterized in that** the first permanent magnet arrangement (101) consists of a ring-like arrangement of permanent magnets (102) which are arranged with a north pole or a south pole adjacent the rear side of the cathode (16) and **in that** a further permanent magnet (104) or a plurality of permanent magnets (104) is or are arranged within the ring-like arrangement and **in that** the polarity of the further magnets (104) or of the further permanent magnets (104) adjacent to the rear side of the cathode (16) is opposite to the polarity of the ring-like arrangement of permanent magnets (104), i.e. is or are executed with a south pole or a north pole respectively.

7. An apparatus (10) in accordance with claim 1 or claim 3, wherein the first electromagnetic arrangement (201) which generates the magnetic field consists of a ring-like arrangement of coils (202) which are each arranged, depending on the direction of the excitation current, with a north pole or with a south pole adjacent to the rear side of the cathode (16) and wherein a further coil (204) or a plurality of further coils (204) is or are arranged within the ring-like arrangement and wherein the direction of the excitation current in the further coil (204) or the further coils (204) is selected or selectable such that the polarity of the further coil (204) or coils (204) adjacent to the rear side of the cathode (16) is opposite to the polarity of the ring-like arrangement of the coils (202), i.e. is or are excutable a south pole or a north pole respectively.

8. An apparatus (10) in accordance with claim 7,
**characterized in that** the ring-like arrangement is at least substantially rectangular or square and the further coils (204) are provided linearly or in a plurality of rows within the ring-like arrangement.

9. An apparatus (10) in accordance with claim 1,wherein the device (201) comprises a plurality of electromagnets or coils (202, 204) which are arranged in the manner of a matrix and are stationary.

10. An apparatus (10) in accordance with claim 9,
wherein the coils (202, 204) arranged in the manner of a matrix can be excited group-wise in order to generate a ring-like arrangement of north poles or south poles adjacent to the rear side of a cathode (16) while the further coil (204) or the further coils (204) within the ring-like arrangement is or are excitable in order to generate an opposed polarity adjacent to the rear side of the cathode (16), whereby the tunnel-like magnetic field generated in front of a portion (106, 108, 110, 112) of the cathode (16) associated with the group and wherein at least one differently selected further group of the coils (202, 204) arranged in the manner of a matrix is excitable in order to generate the tunnel-like magnetic field in front of at least one further portion (106, 108, 110, 112) of the cathode (16).

11. An apparatus (10) in accordance with claim 10,
wherein switches are provided to energize the individual coils (202, 204) in the desired sequence and with the desired polarity.

12. An apparatus (10) in accordance with claim 11,
wherein the switches are semiconductor switches.

13. An apparatus (10) in accordance with any one of the preceding claims,
**characterized in that** the cathode (16) and/or the further cathode (16) is or are respectively exploitable for reactive coating with the aid of one of the members selected from the group comprising the electromagnetic arrangement, the first permanent magnet arrangement and the first electromagnetic arrangement (101; 201) which generates the magnetic field or with the second permanent magnet or with the second electromagnetic arrangement (101; 201).

14. An apparatus (10) in accordance with any one of the previous claims 1, 3 and 7 to 13,
wherein a device is provided for the control of the coil currents and thus the intensity and/or the direction of the magnetic field.

15. A method for the pretreatment or the etching of an article which is arranged in a vacuum chamber (14) of a coating apparatus in accordance with any one of the preceding claims, wherein, during the etching process, the magnetic field is generated at least substantially only in a selected portion (106, 108, 110, 112) of the surface of the cathode (16) in order to concentrate the available power of the HIPIMS power source in that portion, whereby a higher power density is present in that portion and the required power density for the etching process, which must be significantly higher than for the actual coating, can be achieved without having to increase the power of the power source, wherein the magnetic field is provided during the etching process to act in at least one further portion (106, 108, 110, 112) of the surface of the cathode (16) and wherein, during the coating operation, the magnetic field is generated in front of the full surface of the cathode.

## Patentansprüche

1. Vorrichtung (10) zur Vorbehandlung und/oder zur Beschichtung eines Gegenstandes in einer Vakuumkammer (14) mit mindestens einer darin angeordneten Kathode (16), mit mindestens einer HIPIMS-Leistungsquelle (18) sowie mit einer elektromagnetischen Anordnung (101; 201), die erregbar ausgebildet ist, um ein tunnelförmiges Magnetfeld vor der Oberfläche der Kathode zu erzeugen,
wobei die elektromagnetische Anordnung (101; 201) auch derart erregbar ausgebildet ist, das tunnelförmige Magnetfeld vor einem Abschnitt (106, 108, 110, 112) der Fläche der Kathode (16) zu erzeugen, und wobei die elektromagnetische Anordnung auch derart erregbar ausgebildet ist, das Magnetfeld so zu erzeugen, dass es vor zumindest einem weiteren Abschnitt (106, 108, 110, 112) der Fläche der Kathode (16) wirkt.

2. Vorrichtung (10) zur Vorbehandlung und/oder zur Beschichtung eines Gegenstandes in einer Vakuumkammer (14), mit mindestens einer darin angeordneten Kathode (16), mit mindestens einer HIPIMS-Leistungsquelle (18) sowie einer ersten Permanentmagnetanordnung, die derart ausgebildet ist, ein tunnelförmiges Magnetfeld vor der Oberfläche der Kathode zu erzeugen,
**dadurch gekennzeichnet, dass**
eine zweite Permanentmagnetanordnung (101; 201) vorgesehen ist, die derart ausgebildet ist, das tunnelförmige Magnetfeld vor einem Abschnitt (106, 108, 110, 112) der Fläche der Kathode (16) zu erzeugen, und dass die zweite Permanentmagnetanordnung derart ausgebildet ist, dass sie relativ zu der Kathode (16) verstellbar ist, um das Magnetfeld so zu erzeugen, dass es vor zumindest einem weiteren Abschnitt (106, 108, 110, 112) der Fläche der Kathode (16) wirkt.

3. Vorrichtung (10) nach Anspruch 1, wobei die elektromagnetische Anordnung eine erste und eine zweite elektromagnetische Anordnung umfasst, wobei die erste elektromagnetische Anordnung derart ausgebildet ist, ein tunnelförmiges Magnetfeld vor der Oberfläche der Kathode zu erzeugen, wobei die zweite elektromagnetische Anordnung derart ausgebildet ist, das tunnelförmige Magnetfeld vor einem Abschnitt (106, 108, 110, 112) der Fläche der Kathode (16) zu erzeugen, und wobei die zweite elektromagnetische Anordnung ferner derart ausgebildet ist, dass sie relativ zu der Kathode (16) verstellbar ist, um das Magnetfeld so zu erzeugen, dass es vor zumindest einem weiteren Abschnitt (106, 108, 110, 112) die Fläche der Kathode (16) wirkt.

4. Vorrichtung (10) nach Anspruch 2,
**dadurch gekennzeichnet, dass** die erste Permanentmagnetanordnung (102, 104) hinter der Rückseite der Kathode (16) angeordnet ist, und dass die zweite Permanentmagnetanordnung (101) in Bezug auf eine Kathode (16) verstellbar ist, um zu ermöglichen, dass das tunnelförmige Magnetfeld vor der Kathode in den verschiedenen Abschnitten (106, 108, 110, 112) wirkt.

5. Vorrichtung (10) nach einem der Ansprüche 2 oder 3,
**dadurch gekennzeichnet, dass** die Kathode (16) rechtwinklig ist und eine zentrale Längsachse (117) parallel zu den Längsseiten (118, 120) des Rechtecks aufweist, und dass die zweite Permanentmagnetanordnung (101) oder die zweite elektromagnetische Anordnung linear parallel zu der zentralen Längsachse verstellbar und in zumindest zwei Positionen für die Erzeugung des Magnetfeldes in dem jeweiligen Abschnitt aktiv ist.

6. Vorrichtung (10) nach einem der Ansprüche 2 oder 5,
**dadurch gekennzeichnet, dass** die erste Permanentmagnetanordnung (101) aus einer ringförmigen Anordnung aus Permanentmagneten (102) besteht, die mit einem Nordpol oder einem Südpol benachbart der Rückseite der Kathode (16) angeordnet sind, und dass ein weiterer Permanentmagnet (104) oder eine Mehrzahl von Permanentmagneten (104) in der ringförmigen Anordnung angeordnet ist oder sind, und dass die Polarität der weiteren Magneten (104) oder der weiteren Permanentmagneten (104) benachbart der Rückseite der Kathode (16) der Polarität der ringförmigen Anordnung von Permanentmagneten (104) entgegengesetzt ist, d.h. mit Südpolung bzw. Nordpolung ausgeführt ist oder sind.

7. Vorrichtung (10) nach einem der Ansprüche 1 oder 3, wobei die erste elektromagnetische Anordnung (201), die das Magnetfeld erzeugt, aus einer ringartigen Anordnung von Spulen (202) besteht, die jeweils abhängig von der Richtung des Erregungsstromes mit einem Nordpol oder mit einem Südpol benachbart der Rückseite der Kathode (16) angeordnet sind, und wobei eine weitere Spule (204) oder eine Mehrzahl weiterer Spulen (204) in der ringförmigen Anordnung angeordnet ist oder sind, und wobei die Richtung des Erregungsstromes in der weiteren Spule (204) oder den weiteren Spulen (204) so gewählt ist oder wählbar ist, dass die Polarität der weiteren Spule (204) oder Spulen (204) benachbart der Rückseite der Kathode (16) der Polarität der ringförmigen Anordnung der Spulen (202) entgegengesetzt ist, d.h. mit Südpolung bzw. Nordpolung ausführbar ist oder sind.

8. Vorrichtung (10) nach Anspruch 7,
**dadurch gekennzeichnet, dass** die ringförmige Anordnung zumindest im Wesentlichen rechtwinklig oder quadratisch ist und die weiteren Spulen (204) linear oder in einer Mehrzahl von Reihen innerhalb der ringförmigen Anordnung vorgesehen sind.

9. Vorrichtung (10) nach Anspruch 1, wobei die Vorrichtung (201) eine Mehrzahl von Elektromagneten oder Spulen (202, 204) umfasst, die in der Weise einer Matrix angeordnet und stationär sind.

10. Vorrichtung (10) nach Anspruch 9,
wobei die Spulen (202, 204), die in der Weise einer Matrix angeordnet sind, gruppenweise erregt werden können, um eine ringförmige Anordnung von Nordpolen oder Südpolen benachbart der Rückseite einer Kathode (16) zu erzeugen, während die weitere Spule (204) oder die weiteren Spulen (204) innerhalb der ringförmigen Anordnung erregbar ist oder sind, um eine entgegengesetzte Polarität benachbart der Rückseite der Kathode (16) zu erzeugen, wodurch das tunnelförmige Magnetfeld, das vor einem Abschnitt (106, 108, 110, 112) der Kathode (16) erzeugt wird, die der Gruppe zugeordnet ist, und wobei zumindest eine anders gewählte weitere Gruppe der Spulen (202, 204), die in der Weise einer Matrix angeordnet sind, erregbar ist, um das tunnelförmige Magnetfeld vor zumindest einem weiteren Abschnitt (106, 108, 110, 112) der Kathode (16) zu erzeugen.

11. Vorrichtung (10) nach Anspruch 10,
wobei Schalter vorgesehen sind, um die einzelnen Spulen (202, 204) in der gewünschten Abfolge und mit der gewünschten Polarität zu erregen.

12. Vorrichtung (10) nach Anspruch 11,
wobei die Schalter Halbleiterschalter sind.

13. Vorrichtung (10) nach einem der vorhergehenden Ansprüche,
**dadurch gekennzeichnet, dass** die Kathode (16) und/oder die weitere Kathode (16) zur reaktiven Beschichtung unter Zuhilfenahme eines der Elemente verwertbar ist oder sind, die aus der Gruppe gewählt sind, die die elektromagnetische Anordnung, die erste Permanentmagnetanordnung und die erste elektromagnetische Anordnung (101; 201) umfasst, die das Magnetfeld erzeugt, oder des zweiten Permanentmagnets oder der zweiten elektromagnetischen Anordnung (101; 201).

14. Vorrichtung (10) nach einem der vorhergehenden Ansprüche 1, 3 und 7 bis 13,
wobei eine Vorrichtung für die Steuerung des Spulenstroms und somit der Intensität und/oder der Richtung des Magnetfeldes vorgesehen ist.

15. Verfahren zur Vorbehandlung oder zum Ätzen eines Gegenstandes, der in einer Vakuumkammer (14) einer Beschichtungsvorrichtung angeordnet ist, nach einem der vorhergehenden Ansprüche, wobei während des Ätzprozesses das Magnetfeld zumindest im Wesentlichen nur in einem gewählten Abschnitt (106, 108, 110, 112) der Fläche der Kathode (16) erzeugt wird, um die verfügbare Leistung der HIPIMS-Leistungsquelle in diesem Abschnitt zu konzentrieren, wodurch eine höhere Leistungsdichte in diesem Abschnitt vorhanden ist und die erforderliche Leistungsdichte für den Ätzprozess, die wesentlich höher als für die tatsächliche Beschichtung sein muss, erreicht werden kann, ohne die Leistung der Leistungsquelle zu erhöhen, wobei das Magnetfeld während des Ätzprozesses so vorgesehen ist, dass es in zumindest einem weiteren Abschnitt (106, 108, 110, 112) der Fläche der Kathode (16) wirkt, und wobei während des Beschichtungsarbeitsganges das Magnetfeld vor der Oberfläche der Kathode erzeugt wird.

## Revendications

1. Appareil (10) pour le prétraitement et/ou pour le revêtement d'un article dans une chambre sous vide (14) ayant au moins une cathode (16) agencée à l'intérieur, possédant au moins une source de puissance dite "HIPIMS" [High Power Impulse Magnetron Sputtering ou "pulvérisation par magnétron à impulsion de haute puissance"] (18) et possédant également un agencement électromagnétique (101 ; 201) adapté pour être excité afin de générer un champ magnétique semblable à un tunnel en face de la totalité de la surface de la cathode,
dans lequel l'agencement électromagnétique (101 ; 201) est également adapté pour être excité afin de générer le champ magnétique semblable à un tunnel en face d'une portion (106, 108, 110, 112) de la surface de la cathode (16) et dans lequel l'agencement électromagnétique est également adapté pour être excité afin de générer le champ magnétique pour agir en face d'au moins une autre portion (106, 108, 110, 112) de la surface de la cathode (16).

2. Appareil (10) pour le prétraitement et/ou pour le revêtement d'un article dans une chambre sous vide (14) ayant au moins une cathode (16) agencée à l'intérieur, ayant au moins une source de puissance HIPIMS (18) et possédant un premier agencement à aimant permanent adapté pour générer un champ magnétique semblable à un tunnel en face de la totalité de la surface de la cathode,
**caractérisé en ce que**
il est prévu un second agencement à aimant permanent (101 ; 201) qui est adapté pour générer le champ magnétique semblable à un tunnel en face d'une portion (106, 108, 110, 112) de la surface de la cathode (16), et
**en ce que** le second agencement à aimant permanent est adapté pour pouvoir être déplacé par rapport à la cathode (16) afin de générer le champ magnétique pour agir en face d'au moins une autre portion (106, 108, 110, 112) de la surface de la cathode (16).

3. Appareil (10) selon la revendication 1, dans lequel l'agencement électromagnétique comprend un premier et un second agencement électromagnétique,
le premier agencement électromagnétique est adapté pour générer un champ magnétique semblable à un tunnel en face de la totalité de la surface de la cathode,
le second agencement électromagnétique est adapté pour générer le champ magnétique semblable à un tunnel en face d'une portion (106, 108, 110, 112) de la surface de la cathode (16), et dans lequel le second agencement électromagnétique est en outre adapté pour pouvoir être déplacé par rapport à la cathode (16) afin de générer le champ magnétique pour agir en face au moins une autre portion (106, 108, 110, 112) de la surface de la cathode (16).

4. Appareil (10) selon la revendication 2,
**caractérisé en ce que** le premier agencement à aimant permanent (102, 104) est agencé derrière le côté postérieur de la cathode (16), et **en ce que** le second agencement à aimant permanent (101) est déplaçable en relation à une cathode (16) afin de permettre que le champ magnétique semblable à un tunnel agisse en face de la cathode dans les différentes portions (106, 108, 110, 112).

5. Appareil (10) selon la revendication 2 ou 3,
**caractérisé en ce que** la cathode (16) est rectangulaire avec un axe longitudinal central (117) parallèle aux côtés longitudinaux (118, 120) du rectangle, et **en ce que** le second agencement à aimant permanent (101) ou le second agencement électromagnétique est déplaçable de façon linéaire parallèlement à l'axe longitudinal central et est actif dans au moins deux positions pour la génération du champ magnétique dans la portion respective.

6. Appareil (10) selon la revendication 2 ou 5,
**caractérisé en ce que** le premier agencement à aimant permanent (101) est constitué d'un agencement semblable à un anneau d'aimants permanents (102) qui sont agencés avec un pôle nord ou un pôle sud adjacent au côté postérieur de la cathode (16), et **en ce qu'**un autre aimant permanent (104) ou une pluralité d'aimants permanents (104) est/sont agencé(s) à l'intérieur de l'agencement semblable à un anneau, et **en ce que** la polarité de l'autre aimant (104) ou des autres aimants permanents (104) adjacent(s) au côté postérieur de la cathode (16) est opposé à la polarité de l'agencement semblable à un anneau d'aimants permanents (104), c'est-à-dire qu'il est ou qu'ils sont exécuté(s) avec un pôle sud ou un pôle nord respectivement.

7. Appareil (10) selon la revendication 1 ou 3,
dans lequel le premier agencement électromagnétique (201) qui génère le champ magnétique est constitué d'un agencement semblable à un anneau de bobines (202) qui sont agencées chacune, en dépendance de la direction du courant d'excitation, avec un pôle nord ou avec un pôle sud adjacent au côté postérieur de la cathode (16), et dans lequel une autre bobine (204) ou une pluralité d'autres bobines (204) est/sont agencée(s) à l'intérieur de l'agencement semblable à un anneau, et dans lequel la direction du courant d'excitation dans l'autre bobine (204) ou les autres bobines (204) est sélectionné ou susceptible d'être sélectionnée de telle façon que la polarité de l'autre bobine (204) ou des autres bobines (204) adjacente(s) au côté arrière de la cathode (16) est opposée à la polarité de l'agencement semblable à un anneau des bobines (202), c'est-à-dire qu'elle est ou qu'elles sont exécutée(s) avec un pôle sud ou un pôle nord respectivement.

8. Appareil (10) selon la revendication 7,
**caractérisé en ce que** l'agencement semblable à un anneau est au moins sensiblement rectangulaire ou carré et que les autres bobines (204) sont prévues de manière linéaire ou dans une pluralité de rangées à l'intérieur de l'agencement semblable à un anneau.

9. Appareil (10) selon la revendication 1, dans lequel le dispositif (201) comprend une pluralité d'électroaimants ou de bobines (202, 204) qui sont agencé(e)s à la manière d'une matrice et qui sont stationnaires.

10. Appareil (10) selon la revendication 9,
dans lequel les bobines (202, 204) agencés à la manière d'une matrice peuvent être excitées par groupe afin de générer un agencement semblable à un anneau de pôles nord ou de pôles sud adjacents au côté postérieur d'une cathode (16) alors que l'autre bobine (204) ou les autres bobines (204) à l'intérieur de l'agencement semblable à un anneau peut ou peuvent être excitée(s) afin de générer une polarité opposée adjacente au côté postérieur de la cathode (16), grâce à quoi le champ magnétique semblable à un tunnel généré en face d'une portion (106, 108, 110, 112) de la cathode (16) associée au groupe et dans lequel au moins un autre groupe, sélectionné de façon différente, de bobines (202, 204) agencées à la manière d'une matrice peut être excité afin de générer le champ magnétique semblable à un tunnel en face d'au moins une autre portion (106, 108, 110, 112) de la cathode (16).

11. Appareil (10) selon la revendication 10,
dans lequel des commutateurs sont prévus pour exciter les bobines individuelles (202, 204) dans la séquence désirée avec la polarité désirée.

12. Appareil (10) selon la revendication 11,
dans lequel les commutateurs sont des commutateurs à semi-conducteurs.

13. Appareil (10) selon l'une quelconque des revendications précédentes, **caractérisé en ce que** la cathode (16) et/ou l'autre cathode (16) est ou sont respectivement exploitable(s) pour un revêtement réactif avec l'aide d'un élément sélectionné parmi le groupe comprenant l'agencement électromagnétique, le premier agencement à aimant permanent et le premier agencement électromagnétique (101 ; 201) qui génère le champ magnétique ou avec le second aimant permanent ou avec le second agencement électromagnétique (101 ; 201).

14. Appareil (10) selon l'une quelconque des revendications précédentes 1, 3 et 7 à 13,
dans lequel il est prévu un dispositif pour la commande des courants des bobines et ainsi l'intensité et/ou la direction du champ magnétique.

15. Procédé pour le prétraitement ou l'attaque d'un article qui est agencé dans une chambre sous vide (14) d'un appareil de revêtement en accord avec l'une quelconque des revendications précédentes, dans lequel, pendant le processus d'attaque, le champ magnétique est généré au moins sensiblement uniquement dans une portion sélectionnée (106, 108, 110, 112) de la surface de la cathode (16) afin de concentrer la puissance disponible de la source de puissance HIPIMS dans cette portion, grâce à quoi une densité de puissance plus élevée est présente dans cette portion et la densité de puissance requise pour le processus d'attaque, qui doit être significativement plus élevée que pour le revêtement effectif, peut être atteinte sans devoir augmenter la puissance de la source de puissance, dans lequel le champ magnétique est appliqué pendant le processus d'attaque pour agir dans au moins une autre portion (106, 108, 110, 112) de la surface de la cathode (16) et dans lequel, pendant l'opération de revêtement, le champ magnétique est généré en face de la totalité de la surface de la cathode.
